# EUROPÄISCHE PATENTSCHRIFT

(11) **EP 0 891 638 B1**
(45) Veröffentlichungstag und Bekanntmachung des Hinweises auf die Patenterteilung: **01.02.2006**
(21) Anmeldenummer: 97920560.6
(22) Anmeldetag: 27.03.1997
(51) Int. Cl.: H01L 31/048, H01L 31/042

(54) **PHOTOVOLTAIKSYSTEM FÜR EIN SCHRÄGDACH**
PHOTOVOLTAIC SYSTEM FOR A SLOPING ROOF
SYSTEME PHOTOVOLTAIQUE POUR TOIT EN PENTE

(30) Priorität: 29.03.1996 DE 19612489
(43) Veröffentlichungstag der Anmeldung: 20.01.1999
(73) Patentinhaber: Lafarge Roofing Components GmbH & Co. KG, 61437 Oberursel (DE)
(72) Erfinder: RINKLAKE, Manfred, D-64823 Gross-Umstadt (DE); RÖSLER, Norbert, D-61440 Oberursel (DE)
(74) Vertreter: Schickedanz, Willi
(86) Internationale Anmeldenummer: PCT/DE1997/000648
(87) Internationale Veröffentlichungsnummer: WO 1997/037388

(56) Entgegenhaltungen:
- EP-A- 0 549 560
- DE-A- 3 314 637
- DE-A- 4 332 873
- DE-A- 4 408 508
- DE-U- 9 209 228
- FR-A- 2 354 430
- US-A- 4 040 867

## Beschreibung

Die Erfindung betrifft ein Photovoltaiksystem für ein mit Dacheindeckungsplatten eingedecktes Schrägdach, mit in First-Trauf-Richtung verlegbaren Trägerelementen, wobei auf den Trägerelementen stumpf aneinander oder an benachbarte Dacheindeckungsplatten angrenzend photovoltaische Zellen aufweisende plattenförmige photovoltaische Module angeordnet sind die in First-Trauf-Richtung schuppenartig überdeckend verlegbar sind, deren Länge größer ist als die größte Decklänge einer Dacheindeckungsplatte und deren Breite größer ist als die Systemdeckbreite der Dacheindeckungsplatten.

Ein derartiges Photovoltaiksystem ist beispielsweise aus der DE 94 09 453.9 U1 bekannt. Bei diesem System sind photovoltaische Module in Längsrichtung des Daches schuppenartig überdeckend angeordnet. Als Längsrichtung wird nachfolgend die Linie First-Traufe, als Querrichtung eine Parallele zum First oder zur Traufe bezeichnet. Als Trägerelemente sind in First-Trauf-Richtung verlegte Holzprofile vorgesehen, die an ihrem firstseitigen Ende auf einer Dachlatte und an ihrem traufseitigen Ende auf einer parallel zu einer Dachlatte an dieser angrenzend verlegten Holzlatte aufliegen. Die Holzlatte ragt über die Oberkante der Dachlatte um annähernd die Dicke des photovoltaischen Moduls hinaus. Die Holzprofile weisen auf ihrer Oberfläche eine in Längsmitte verlaufende Vertiefung auf, so daß diese bei Anordnung an den Rändern zweier stumpf aneinanderstoßender photovoltaischer Module zur Ableitung von in den Spalt eingedrungenem Wasser dient. Nachteilig ist bei diesem System, daß parallel zu den Dachlatten zusätzliche Holzlatten verlegt werden müssen und daß zusätzliche den traufseitigen Rand der photovoltaischen Module umgreifende Sturmhaken zur Befestigung erforderlich sind.

Ein Photovoltaiksystem für ein mit Dacheineindeckungsplatten eingedecktes Schrägdach ist aus der EP-A-0 549 560 bekannt. Das Photovoltaiksystem weist rahmenartige Trägerelemente auf, die in First-Trauf-Richtung schuppenartig überdeckend verlegbar sind. In ein Trägerelement ist jeweils ein photovoltaische Zellen aufweisendes plattenförmiges photovoltaisches Modul einsetzbar, dessen Länge größer ist als die größte Decklänge einer Dacheindeckungsplatte und dessen Breite größer ist als die Systemdeckbreite einer Dacheindeckungsplatte.

Die seitlichen Längsränder eines Trägerelements sind in der für eine Dacheindeckungsplatte üblichen Weise als Wasserfalz und als Deckfalz ausgebildet. Auf diese Weise können Trägerelemente und Dacheindeckungsplatten so in einer traufparallelen Reihe verlegt werden, daß ein Trägerelement mit seinem als Deckfalz ausgebildeten seitlichen Längsrand jeweils den als Wasserfalz ausgebildeten seitlichen Längsrand des benachbarten Trägerelements bzw. der benachbarten Dacheindeckungsplatte überdeckt. Bei dem bekannten Photovoltaiksystem ist eine stumpfstoßende Verlegung der photovoltaischen Module nicht möglich.

Aus der FR-A-2 354 430 ist ein photovoltaisches Modul bekannt, das einen Solarzellen aufweisenden traufseitigen Abschnitt und einen von Solarzellen freien firstseitigen Abschnitt aufweist. Die photovoltaischen Module sind in First-Trauf-Richtung schuppenartig überdeckend verlegbar, wobei ein photovoltaisches Modul mit seinem firstseitigen Abschnitt unmittelbar auf einer in firstparalleler Richtung verlaufenden Dachlatte aufliegt und von dem mit Solarzellen versehenen traufseitigen Abschnitt des in First-Trauf-Richtung höheren photovoltaischen Moduls überdeckt wird. Mit dem traufseitigen Abschnitt stützt sich ein photovoltaisches Modul jeweils auf dem von Solarzellen freien Abschnitt des in First-Trauf-Richtung tieferen photovoltaischen Moduls ab. Die photovoltaischen Module sind firstseitig nicht an der Dachlatte fixiert, so daß an jeder Dachlatte ein Haken angeordnet ist, der den firstseitigen Rand einer Dachlatte und den firstseitigen Rand eines überdeckten photovoltaischen Moduls umgreift. Der Haken ist zwischen den sich schuppenartig überdeckenden photovoltaischen Modulen hindurch geführt und umgreift den traufseitigen Rand des überdeckenden photovoltaischen Moduls. Auf diese Weise verhindert der Haken eine Verschiebung des überdeckenden photovoltaischen Moduls zur Traufe hin.

Der Erfindung liegt die Aufgabe zugrunde ein Photovoltaiksystem der eingangs geschilderten Art zu schaffen, das als Baukastensystem in eine Dacheindeckung aus kleinformatigen Dacheindeckungsplatten integrierbar und auch nachträglich in ein bereits eingedecktes Dach ohne Anpassungsarbeiten einbaubar ist und den Austausch von photovoltaischen Modulen ohne Montagearbeiten am Befestigungssystem ermöglicht.

Die Aufgabe wird erfindungsgemäß dadurch gelöst, daß an dem firstseitigen Ende der Trägerelemente eine Stütze vorgesehen ist, welche bei zwei in derselben Fallinie angeordneten Trägerelementen das firstnahe Trägerelement auf dem in Traufrichtung benachbarten Trägerelement in einer Höhe oberhalb der Oberfläche des auf diesem aufliegenden photovoltaischen Moduls längsverschiebbar abstützt, daß die Breite eines photovoltaischen Moduls gleich einem ganzzahligen Vielfachen der Systemdeckbreite der Dacheindeckungsplatten ist, daß in First-Trauf-Richtung die Länge der photovoltaische Zellen aufweisenden Fläche innerhalb eines photovoltaischen Moduls kürzer ist als die kürzeste Decklänge einer benachbarten Dacheindeckungsplatte, so daß ein photovoltaisches Modul firstseitig einen von photovoltaischen Zellen freien Randabschnitt aufweist und daß auf einem Trägerelement und unterhalb des photovoltaischen Moduls ein Unterdeckelement vorgesehen ist, das einen unter dem Längsrand eines photovoltaischen Moduls positionierbaren Wasserlauf aufweist.

Zur Verlegung eines ersten photovoltaischen Moduls sind zumindest zwei in einer traufparallelen Reihe und in zueinander parallelen in First-Trauf-Richtung verlaufenden Linien angeordnete Trägerelemente erforderlich. Das unterste Trägerelement einer Linie wird mit seinem firstseitigen Endabschnitt an einer ersten Dachlatte befestigt, während sein traufseitiger Endabschnitt eine in Traufrichtung benachbarte Dacheindeckungsplatte überdeckt und beispielsweise mit einem sturmhaken an einer traufseitigen zweiten Dachlatte befestigt wird. Das erste Modul wird anschließend auf die Oberseite der unteren Trägerelemente aufgelegt. Das in derselben Linie zu verlegende firstnahe Trägerelement wird im Bereich seines traufseitigen Endabschnitts mit der Stütze des unteren Trägerelements verbunden und firstseitig auf einer firstseitigen dritten Dachlatte aufgelegt. Hierbei wird das firstnahe Trägerelement in einer Höhe oberhalb der Oberfläche des ersten Moduls abgestützt, so daß es zur Anpassung an den jeweiligen Dachlattenabstand in Trauf-Richtung verschoben werden kann, ohne dabei an das erste Modul anzustoßen.

Das firstnahe Trägerelement wird beim Verschieben so positioniert, daß sein firstseitiger Endabschnitt einerseits an der dritten Dachlatte befestigt werden kann und sein traufseitiger Endabschnitt andererseits das erste Modul firstseitig überdeckt. Der überdeckende traufseitige Endabschnitt des firstnahen Trägerelements verhindert daher ein Abheben des ersten Moduls vom unteren Trägerelement. Auf zwei parallele firstnahe Trägerelemente wird anschließend ein zweites Modul aufgelegt, das einen firstseitigen Randabschnitt des ersten Moduls schuppenartig überdeckt.

Die auf den Trägerlementen in einer traufparallelen Reihe verlegten photovoltaischen Module können stumpf aneinander oder an benachbarte Dacheindeckungsplatten austoßen. Hierbei entsteht an jeder Stoßstelle ein Spalt, der gegen das Eindringen von Regenwasser abzudichten ist. Bei dem erfindungsgemäßen Photovoltaiksystem sind daher auf einem Trägerelement und unterhalb des photovoltaischen Moduls Unterdeckelemente verlegbar, deren Wasserläufe jeweils unter dem Längsrand eines photovoltaischen Moduls positionierbar sind. Diese Unterdeckelemente können beispielsweise aus dünnem Kunststoff-Material bestehen und im einfachsten Fall als Ablaufrinne mit etwa U-förmigen Querschnitt ausgeführt sein.

Die photovoltaischen Module dieses Photovoltaiksystems können aufgrund ihrer Abmessungen anstelle mehrerer handelsüblicher Dacheindeckungsplatten eingebaut werden. Vorteilhafterweise entspricht die Länge der einer Dacheindeckungsplatte. Da die Deckbreite von Betondachsteinen üblicherweise 30 cm und die von Tondachziegeln 20 cm beträgt, sollte die Breite eines photovoltaischen Moduls 60 cm oder ein Vielfaches davon betragen. Die Breite eines photovoltaischen Moduls kann beispielsweise so gewählt sein, daß sie der Deckbreite von vier Betondachsteinen bzw. von sechs Tondachziegeln entspricht, so daß sich für das photovoltaische Modul eine Außenabmessung von etwa 38 cm x 120 cm ergibt. Davon kann eine Fläche von 25 cm x 114 cm mit photovoltaischen Elementen belegt sein, wobei an den Längsseiten je ein freier Rand von 3 cm, zur Traufe hin von 2 cm und zum First hin von 11 cm verbleibem. Ein derartiges photovoltaisches Modul kann derzeit mit siliziumzellen eine elektrische Leistung von etwa 35 Watt erzeugen. Eine Generatoreinheit sollte wenigstens 20 Module aufweisen.

Bei versetzter Anordnung der Dacheindeckungsplatten sind diese in einer Reihe um die halbe Deckbreite gegenüber der first- oder traufseitig benachbarten Reihe versetzt. Werden mehrere Module schuppenartig in First-Trauf-Richtung einander teilweise überdeckend verlegt, so sind diese bei angrenzender Verlegung an eine versetzte Dacheindeckung ebenfalls in jeder Reihe um die halbe Deckbreite einer Dacheindeckungsplatte versetzt, also um etwa 10 bis 15 cm. Da die Trägerelemente in Querrichtung frei angeordnet werden können, ist trotzdem die Montage in einer Linie möglich, beispielsweise etwa in den Viertelpunkten entsprechenden Bereichen, ohne daß ein Randausgleich mit Dacheindeckungsplatten von halber Breite erforderlich ist.

Der Abstand der Dachlatten kann wegen der von der Dachneigung abhängigen Überdeckung der Dacheindeckungsplatten von Dach zu Dach variieren. Die größte Überdeckung und damit die kleinste Decklänge hat ein Dach mit flachem Neigungswinkel. Um das Photovoltaiksystem in beliebige Dächer integrieren zu können ist es daher vorteilhaft, wenn die photovoltaische Zellen aufweisende Fläche innerhalb eines photovoltaischen Moduls nicht länger ist als die kürzeste Decklänge. Auf diese Weise wird die Abschattung von photovoltaischen Zellen vermieden, die in Grenzfällen auftreten könnte, wenn ein für eine größere Decklänge vorgesehenes Modul versehentlich auf einem Dach mit geringerer Decklänge verlegt würde. Das System wird dadurch äußerst anwenderfreundlich und kann auch im "do-it-yourself" Verfahren verlegt werden.

Die Montage des Photovoltaiksystems ist besonders einfach, wenn bezogen auf die Ebene der Dachunterkonstruktion die Höhe der Oberseite eines Trägerelements zumindest gleich der Höhe des Wasserfalzes einer seitlich benachbarten Dacheindeckungsplatte ist, so daß der dem Wasserfalz einer Dacheindeckungsplatte benachbarte Rand eines photovoltaischen Moduls den Wasserfalz überdeckend und der dem Deckfalz einer Dacheindeckungsplatte benachbarte Rand eines photovoltaischen Moduls an den Deckfalz stoßend verlegbar ist.

Besonders gefällig kann das Photovoltaiksystem in ein mit handelsüblichen flachen Dacheindeckungsplatten aus Beton oder Ton gedecktes Schrägdach integriert werden. Flache Dacheindeckungsplatten aus Beton sind üblicherweise 42 cm lang, 33 cm breit und 2,2 cm hoch. Sie haben eine Deckbreite von 30 cm und je nach Dachneigung eine Decklänge von 31 cm bis 34 cm. Die Höhe des Wasserfalzes beträgt 1,2 cm über der Unterkante, so daß photovoltaische Module bündig mit der Oberseite der Dacheindeckungsplatten verlegt werden können.

Die Stütze kann auf der Oberseite eines Trägerelements angeordnet sein.

Das Einlegen und Auswechseln eines Moduls ist ohne Werkzeug möglich, wenn ein Trägerelement an seinem traufseitigen Ende eine den Rand eines Moduls umgreifende Aufnahme aufweist und die lichte Weite zwischen dem Rand der Aufnahme und der an dem Trägerelement angeordneten Stütze wenigstens gleich der Länge eines Moduls ist. Auf diese Weise kann ein Modul bei der Montage in Richtung First bis an die Stützen der Trägerelemente geschoben werden, wird dann auf die Trägerelemente aufgelegt und anschließend in Traufrichtung in die Aufnahme eingeschoben. Das Herausnehmen erfolgt in umgekehrter Reihenfolge. Es versteht sich, daß auch am Modul eine das traufseitige Ende des Trägerelements umgreifende Aufnahme vorgesehen sein kann. Vorteilhafterweise sind die elektrischen Anschlüsse als Steckverbindungen ausgeführt.

Eine besondere Sturmsicherung ist bei dem Photovoltaiksystem nicht erforderlich, wenn die Stütze eines Trägerelements als knebelartiges Kupplungselement ausgebildet ist, das in einen Längsschlitz auf der Unterseite des aufliegenden Trägerelements eingreift, um ein Abheben des aufliegenden Trägerelements zu verhindern.

Die photovoltaischen Module des Photovoltaiksystems sind besonders flach, wenn sie rahmenlos ausgeführt sind.

Um insbesondere ein derartiges an seiner Unterseite glattes photovoltaisches Modul dicht einzudecken, ist es vorteilhaft, wenn sich das Unterdeckelement zumindest über die gesamte Breite eines photovoltaischen Moduls erstreckt und einen schnee- und regensicher abdichtend ausgebildeten traufseitigen Rand aufweist, der im Überdeckungsbereich zweier photovoltaischer Module anordbar ist. Da im Überdeckungsbereich zweier schuppenartig verlegter etwa 1 cm dicker Module auf einem mit Dacheindeckungsplatten von 2,2 cm Dicke ein Spalt von rund 1,2 cm klafft, kann das Unterdeckelement zur Abdichtung dieses Spalts herangezogen werden.

Diese Abdichtung erfolgt nur gegen eindringendes Wasser, wenn das Unterdeckelement an seinem traufseitigen Rand Lüftungsöffnungen aufweist. An diese Öffnungen kann sich ein Labyrinth anschließen, das auch gegen Flugschnee dichtet. Eine Luftströmung ist jedoch anzustreben, um einen kühlenden Luftstrom entlang der Unterseite eines photovoltaischen Moduls zu leiten. Dadurch wird eine zu starke Aufheizung und damit verbundene Leistungsminderung eines photovoltaischen Moduls verhindert. Vorteilhafterweise wird die am firstseitigen Rand abströmende erwärmte Luft entlang der Unterseite des folgenden Unterdeckelements geführt, so daß erwärmte Luft bis zum First nicht mehr in Kontakt mit weiteren photovoltaischen Modulen gelangt.

In der Zeichnung ist ein bevorzugtes Ausführungsbeispiel der Erfindung dargestellt, das im folgenden näher erläutert wird.

Es zeigt
- Fig. 1: ein erfindungsgemäßes Photovoltaiksystem in der Draufsicht,
- Fig. 2: das Photovoltaiksystem aus Fig. 1 im Schnitt II - II und
- Fig. 3: das Photovoltaiksystem aus Fig. 1 im Längsschnitt III - III.

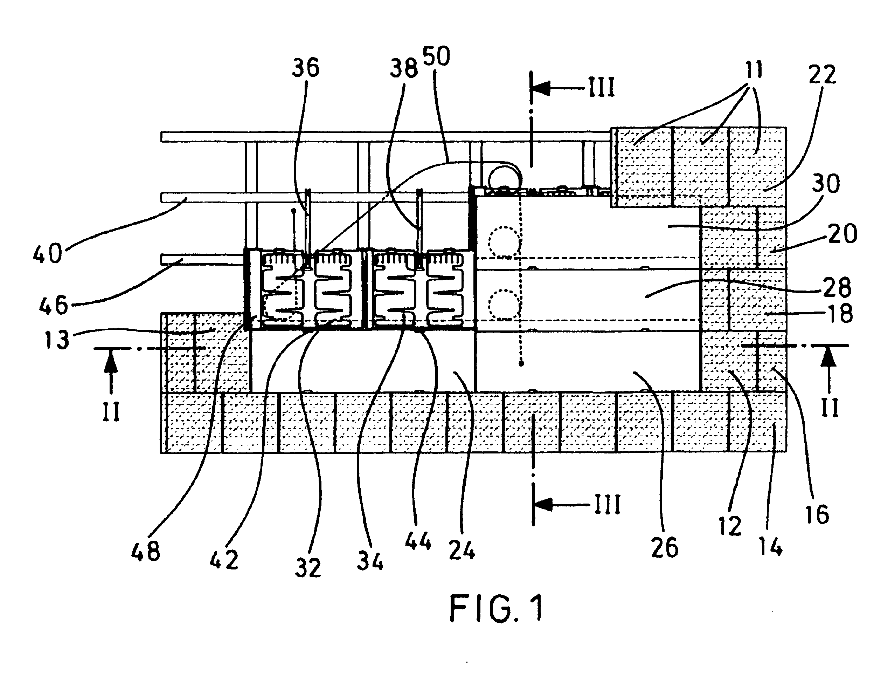

Fig. 1 zeigt ein mit flachen Dacheindeckungsplatten 11, 12, 13 aus Beton in versetzten Reihen 14, 16, 18, 20, 22 teilweise eingedecktes Schrägdach in der Draufsicht schematisch im Bauzustand. In den Reihen 16, 18, 20 sind photovoltaische Module 24, 26, 28 bzw. 30 dargestellt. In Reihe 18 sind in einem nicht mit photovoltaischen Modulen eingedeckten Bereich Unterdeckelemente 32, 34 dargestellt und in Reihe 30 sind in einem ersten Bauzustand Trägerelemente 36, 38 dargestellt, die an ihren firstseitigen Enden auf einer Dachlatte 40 befestigt sind. An ihren traufseitigen Enden sind die Trägerelemente 36, 38 auf in derselben Fallinie angeordneten traufseitig benachbarten Trägerelementen 42, 44 abgestützt, die wiederum firstseitig an der unter ihnen befindlichen Dachlatte 46 befestigt sind. Die Unterdeckelemente 32, 34 weisen etwa die halbe Breite eines photovoltaischen Moduls 24, 26, 28, 30 auf und besitzen jeweils an ihrem in Fig. 1 links dargestellten Rand wie das Unterdeckelement 32 einen trogförmigen Wasserlauf 48. Die in der ersten Reihe 16 nebeneinander verlegten photovoltaischen Module 24 und 26 stoßen stumpf aneinander. An seinem anderen Ende liegt das photovoltaische Modul 26 auf dem Wasserlauf der benachbarten Dacheindeckungsplatte 12 auf, während das photovoltaische Modul 24 an seinem anderen Ende stumpf an den Deckfalz der ihm benachbarten Dacheindeckungsplatte 13 stößt. Unterhalb der stumpfen Stoßfugen befinden sich Wasserläufe von hier nicht sichtbaren unter den photovoltaischen Modulen 24 und 26 angeordneten Unterdeckelementen, die identisch mit den in Reihe 18 sichtbaren Unterdeckelementen 32, 34 sind. Zur elektrischen Verbindung der einzelnen photovoltaischen Module 24, 26, 28, 30 untereinander und mit weiteren hier nicht dargestellten Modulen sind Kabel 50 vorgesehen, die mittels Steckverbindungen an die Module angeschlossen sind.

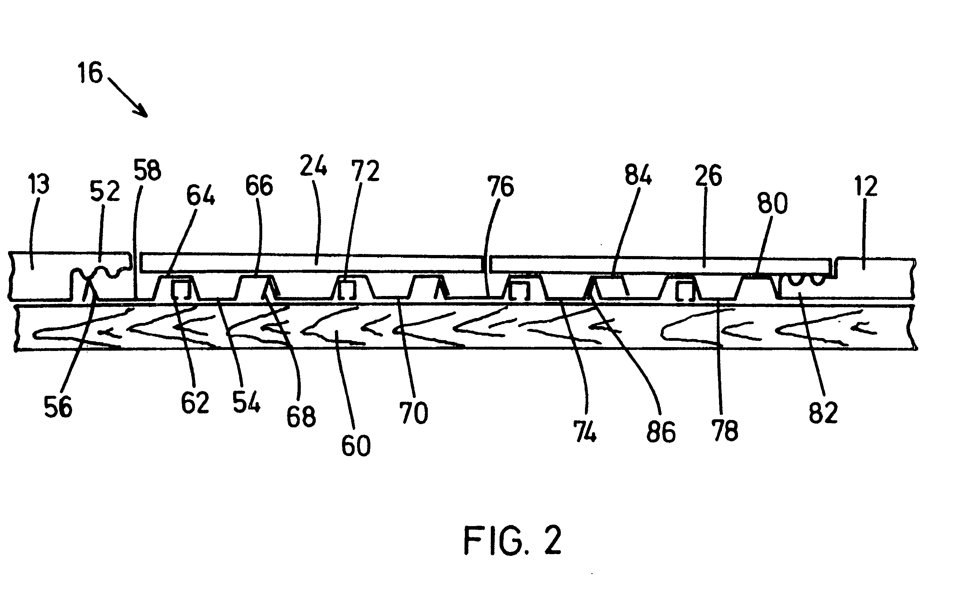

In Fig. 2 ist Reihe 16 des Dachs aus Fig. 1 im traufparallelen Schnitt II-II dargestellt. Hierbei befindet sich links die erste Dacheindeckungsplatte 13, die rechtsseitig einen hochliegenden Deckfalz 52 aufweist. Auf die erste Dacheindeckungsplatte 13 folgt ein erstes Unterdeckelement 54, das mit einer am linken Längsrand verlaufenden schmalen Hochsicke 56 an der Unterseite des Deckfalzes 52 der ersten Dacheindeckungsplatte 13 anliegt, während der freie Längsrand des Deckfalzes 52 über einem Wasserlauf 58 des ersten Unterdeckelements 54 angeordnet ist. Das erste Unterdeckelement 54 ist in seiner Querrichtung etwa mittig von einem an einer Dachlatte 60 befestigten ersten Trägerelement 62 durchsetzt, das in einer etwa in der Mitte des ersten Unterdeckelements 54 angeordneten Hochsicke 64 in Querrichtung verschiebbar aufgenommen ist. Mit einer am rechten Längsrand verlaufenden breiten Hochsicke 66 überdeckt das erste Unterdeckelement 54 die am linken Längsrand verlaufende schmale Hochsicke 68 eines zweiten Unterdeckelements 70, das in gleicher Weise mit einem zweiten Trägerelement 72 befestigt ist.

Damit zwei benachbarte Unterdeckelemente 54, 70 ihre maximale Streckung in Querrichtung erhalten, ist das zweite Unterdeckelement 70 bei der Verlegung in traufparalleler Richtung nach rechts gezogen worden, so daß seine von der breiten Hochsicke 66 des ersten Unterdeckelements 54 aufgenommene schmale Hochsicke 68 unmittelbar an der rechten Seitenfläche der breiten Hochsicke 66 des ersten Unterdeckelements 54 anliegt. Auf den beiden Trägerelementen 62, 72 ist das erste photovoltaische Modul 24 angeordnet, das links stumpf an den Deckfalz 52 der ersten Dacheindeckungsplatte 13 und rechts stumpf an das benachbarte zweite photovoltaische Modul 26 anstößt. Rechts von dem zweiten Unterdeckelement 70 ist in der zuvor beschriebenen Weise ein drittes Unterdeckelement 74 verlegt. Die Stoßstelle der photovoltaischen Modul 24, 26 ist hierbei oberhalb des Wasserlaufes 76 des dritten Unterdeckelements 74 angeordnet.

Rechts von dem dritten Unterdeckelement 74 ist ähnlich der zuvor beschriebenen Weise ein viertes Unterdeckelement 78 verlegt, welches mit einer am rechten Längsrand verlaufenden breiten Hochsicke 80 stumpf an den linksseitigen tiefliegenden Wasserfalz 82 der zweiten Dacheindeckungsplatte 12 stößt. Das dritte und das vierte Unterdeckelement 74, 78 sind vom zweiten photovoltaischen Modul 26 überdeckt.

Da die ersten drei Unterdeckelemente 54, 70, 74 jeweils mit maximaler Streckung verlegt worden sind, und das vierte Unterdeckelement 78 stumpf an die zweite Dacheindeckungsplatte 12 anstößt, ist die erforderliche Deckbreite des vierten Unterdeckelements 78 um die Breite des Wasserfalzes 82 der zweiten Dacheindeckungsplatte 12 geringer als bei maximaler Streckung. Bei der Verlegung ist das vierte Unterdeckelement 78 daher um die Breite des Wasserfalzes 82 in traufparalleler Richtung nach links verschoben worden, so daß seine von der breiten Hochsicke 84 des dritten Unterdeckelements 74 aufgenommene schmale Hochsicke 86 unmittelbar an der linken Seitenfläche der breiten Hochsicke 84 des dritten Unterdeckelements 74 anliegt. Die Deckbreite der Unterdeckelemente 54, 70, 74, 78 ist daher problemlos an die jeweiligen baulichen Gegebenheiten anpaßbar.

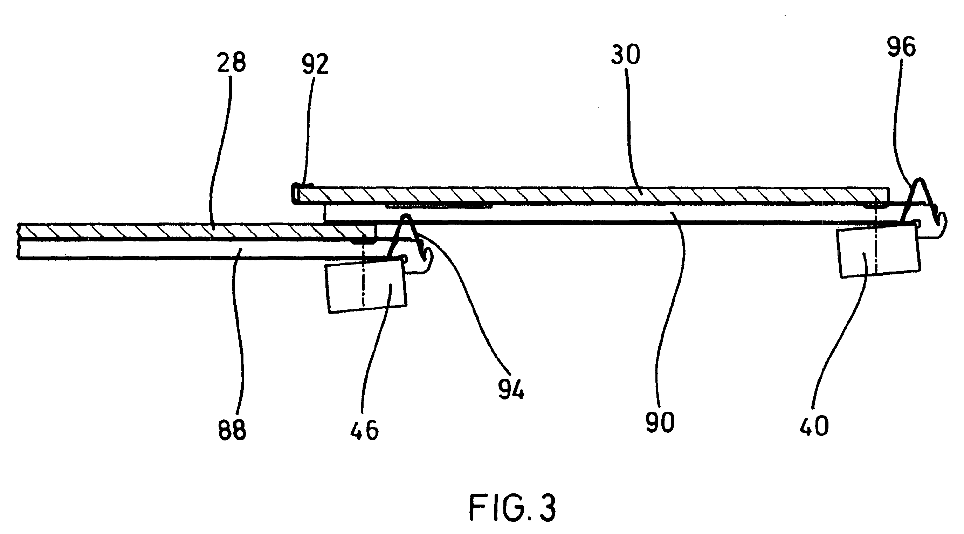

Fig. 3 zeigt das Photovoltaiksystem aus Fig. 1 im Längsschnitt entlang der Linie III - III, wobei lediglich die photovoltaischen Module 28 und 30 dargestellt sind. Diese liegen auf Trägerelementen 88 bzw. 90 auf. Am traufseitigen Ende ist, wie hier am Trägerelement 90 dargestellt, eine U-förmige Aufnahme 92 angeformt, die den traufseitigen Rand des aufliegenden photovoltaischen Moduls 30 klauenartig umgreift. Jedes der Trägerelemente 88, 90 liegt an seinem firstseitigen Ende auf einer Dachlatte 46 bzw. 40 auf und ist an dieser festgeschraubt. Am traufseitigen Ende des Trägerelements 90 ist beispielhaft die für alle Trägerelemente prinzipiell gleiche längsverschiebbare Abstützung mittels einer Stütze 94 auf dem firstseitigen Ende des darunter liegenden Trägerelements 88 dargestellt. Am firstseitigen Ende des Trägerelements 90 ist eine identische Stütze 96 für ein nachfolgendes überdeckendes Trägerelement vorgesehen.

Die Abstützung des firstnahen Trägerelements 90 erfolgt in einer Höhe, die zumindest gleich der Dicke des Moduls 28 ist. Auf diese Weise kann das firstnahe Trägerelement 90 bei der Montage gegenüber dem unteren Trägerelement 88 und dem daraufliegenden Modul 28 in Trauf-Richtung verschoben werden, bis sein traufseitiger Endabschnitt das Modul 28 überdeckt. Das auf dem firstnahen Trägerelement 90 aufliegende Modul 30 ist, bedingt durch den traufseitigen Endabschnitt des firstnahen Trägerelements 90, beabstandet zum Modul 28 angeordnet und überdeckt einen firstseitigen Randabschnitt des Moduls 28.

## Patentansprüche

1. Photovoltaiksystem für ein mit Dacheindeckungsplatten (11, 12, 13) eingedecktes Schrägdach mit in First-Trauf-Richtung verlegbaren Trägerelementen (36, 38, 88, 90), wobei auf den Trägerelementen (36, 38, 88, 90) stumpf aneinander oder an benachbarte Dacheindeckungsplatten angrenzend photovoltaische Zellen aufweisende plattenförmige photovoltaische Module (24, 26, 28, 30) angeordnet sind die in First-Trauf-Richtung schuppenartig überdeckend verlegbar sind, deren Länge größer ist als die größte Decklänge einer Dacheindeckungsplatte (11, 13) und deren Breite größer ist als die Systemdeckbreite der Dacheindeckungsplatten (11, 12, 13),
**dadurch ggekennzeichnet,**
**daß** an dem firstseitigen Ende der Trägerelemente (36, 38, 88, 90) eine Stütze (94, 96) vorgesehen ist,
welche bei zwei in derselben Fallinie angeordneten Trägerelementen (36, 38, 88, 90) das firstnahe Trägerelement (90) auf dem in Traufrichtung benachbarten Trägerelement (88) in einer Höhe oberhalb der Oberfläche des auf diesem aufliegenden photovoltaischen Moduls (28) längsverschiebbar abstützt,
daß die Breite eines photovoltaischen Moduls (24, 26, 28, 30) gleich einem ganzzahligen Vielfachen der Systemdeckbreite der Dacheindeckungsplatten (11, 12, 13) ist,
daß in First-Trauf-Richtung die Länge der photovoltaische Zellen aufweisenden Fläche innerhalb eines photovoltaischen Moduls (24, 26, 28, 30) kürzer ist als die kürzeste Decklänge einer benachbarten Dacheindeckungsplatte (11, 13), so daß ein photovoltaisches Modul (24, 26, 28, 30) firstseitig einen von photovoltaischen Zellen freien Randabschnitt aufweist und
daß auf einem Trägerelement (62) und unterhalb des photovoltaischen Moduls (24) ein Unterdeckelement (32, 34) vorgesehen ist,
das einen unter dem Längsrand eines photovoltaischen Moduls (24) positionierbaren Wasserlauf (58) aufweist.

2. Photovoltaiksystem nach Anspruch 1,
**dadurch gekennzeichnet,**
**daß** bezogen auf die Ebene der Dachunterkonstruktion die Höhe der Oberseite eines Trägerelements (36, 38) zumindest gleich der Höhe des Wasserfalzes (82) einer seitlich benachbarten Dacheindeckungsplatte (12) ist, so daß der Raud eines an der Wasserfalz-Seite einer benachbarten Dacheindeckungsplatte (12) zu verlegenden photovoltaischen Moduls (26) den Wasserfalz (82) überdeckend und der Raud eines an der Deckfalz-Seite einer benachbarten Dacheindeckungsplatte (13) zu verlegenden photovoltaischen Moduls (24) an den Deckfalz (52) stoßend verlegbar ist.

3. Photovoltaiksystem nach Anspruch 1 oder 2,
**dadurch gekennzeichnet**,
daB die Stütze (94, 96) auf der Oberseite eines Trägerelements (88) angeordnet ist.

4. Photovoltaiksystem nach Anspruch 3,
**dadurch gekennzeichnet,**
**daß** ein Trägerelement (90) an seinem traufseitigen Ende eine den Rand eines photovoltaischen Moduls (30) umgreifende Aufnahme (92) aufweist
und **daß** die lichte Weite zwischen dem Rand der Aufnahme (92) und der an dem Trägerelement angeordneten Stütze (94) wenigstens gleich der Länge eines Moduls (30) ist.

5. Photovoltaiksystem nach Anspruch 3 oder 4,
**dadurch gekennzeichnet,**
**daß** die Stütze (94) eines Trägerelements (88) als knebelartiges Kupplungselement ausgebildet ist, das in einen Längsschlitz auf der Unterseite des aufliegenden Trägerelements (90) eingreift, um eine Abheben des aufliegenden Trägerelements (90) zu verhindern.

6. Photovoltaiksystem nach einem der Ansprüche 1 bis 5,
**dadurch gekennzeichnet,**
**daß** die photovoltaischen Module (24, 26, 28, 30) rahmenlos ausgeführt sind.

7. Photovoltaiksystem nach einem der Ansprüche 1 bis 6,
**dadurch gekennzeichnet,**
**daß** sich Unterdeckelemente (32, 34) über die gesamte Breite eines photovoltaischen Moduls erstrecken und einen schnee- und regensicher abdichtend ausgebildeten traufseitigen Rand aufweisen, der im Überdeckungsbereich zweier photovoltaischer Module (28, 26 oder 30, 28) anordbar ist.

8. Photovoltaiksystem nach Anspruch 7,
**dadurch gekennzeichnet,**
**daß** das Unterdeckelement (32, 34) an seinem traufseitigen Rand Lüftungsöffnungen aufweist.

## Claims

1. A photovoltaic system for a sloping roof covered with roof-covering panels (11, 12, 13), with bearing elements (36, 38, 88, 90) which can be laid in the crest-gutter direction, whereby panel-shaped photovoltaic modules (24, 26, 28, 30) having photovoltaic cells are arranged butted against one another or delimiting adjacent roof-covering panels on the bearing elements (36, 38, 88, 90), which can be laid in the crest-gutter direction and overlap like scales, whereof the length is greater than the greatest coverage length of a roof-covering panel (21, 13) and whereof the width is greater than the system covering width of the roof-covering panels (11, 12, 13),
**characterised in that**
provided on the end crest-side of the bearing elements (36, 38, 88, 90) is a stay (94, 96),
which, in two bearing elements (36, 38, 88, 90) arranged in the same line of slope, braces the bearing element (90) near the crest on the adjacent bearing element (88) in the gutter direction at a height above the surface of the photovoltaic module (28) resting on the latter so as to be able to slide longitudinally,
that the width of a photovoltaic module (24, 26, 28, 30) is equal to an integral multiple of the system coverage width of the roof covering panels (11, 12, 13),
that in the crest-gutter direction the length of the surface exhibiting photovoltaic cells inside a photovoltaic module (24, 26, 28, 30) is shorter than the shortest coverage length of an adjacent roof-covering panel (12, 23), so that on its crest side a photovoltaic module (24, 26, 28, 30) has an edge section free of photovoltaic cells and
that on a bearing element (62) and under the photovoltaic module (24) a underlying covering element (32, 34, 54) is provided, which has a water course (58) which can be positioned below the longitudinal edge of a photovoltaic module (24).

2. The photovoltaic system as claimed in Claim 1, **characterised in that**, with reference to the plane of the underlying roof construction, the height of the top side of a bearing element (36, 38) is at least equal to the height of the water rabbet (82) of a laterally adjacent roof-covering panel (12), so that the edge of a photovoltaic module (26) to be laid on the water rabbet side of an adjacent roof-covering panel (12) overlapping the water rabbet (82) and the edge of a photovoltaic module (24) to be laid on the covering rabbet side of an adjacent roof-covering panel (13) can be butted onto the covering rabbet (52).

3. The photovoltaic system as claimed in Claim 1 or 2, **characterised in that** the stay (94, 96) is arranged on the top side of a bearing element (88).

4. The photovoltaic system as claimed in Claim 3, **characterised in that** on its gutter-side end a bearing element (90) has a pickup (92) gripping over the edge of a photovoltaic module (30), and that the inner width between the edge of the pickup (92) and the stay (94) arranged on the bearing element is at least equal to the length of a photovoltaic module (30).

5. The photovoltaic system as claimed in any one of Claims 3 or 4, **characterised in that** the stay (94) of a bearing element (88) is designed as a toggle-like coupling element, which engages in a longitudinal slot on the underside of the superjacent bearing element (90), to prevent the superjacent bearing element (90) from lifting.

6. The photovoltaic system as claimed in any one of Claims 1 to 5, **characterised in that** the photovoltaic modules (24, 26, 28, 30) are designed without a frame.

7. The photovoltaic system as claimed in any one of Claims 1 to 6, **characterised in that** underlying covering elements (32, 34) extend over the entire width of a photovoltaic module and have a gutter-side edge designed to seal securely against snow and rain, which can be arranged in the overlapping region of two photovoltaic modules (28, 26 or 30, 28).

8. The photovoltaic system as claimed in Claim 7, **characterised in that** the underlying covering element (32, 34) has ventilation openings on its gutter-side edge.

## Revendications

1. Système photovoltaïque pour un toit en pente recouvert avec des plaques de couverture de toit (11, 12, 13) avec des éléments supports (36, 38, 88, 90) pouvant être posés en direction du larmier de faîtage, des modules (24, 26, 28, 30) photovoltaïques, en forme de plaques, présentant des cellules voltaïques contiguës bord à bord entre elles ou à des plaques voisines de couverture de toit, étant disposés sur les éléments supports (36, 38, 88, 90), lesquels modules peuvent être posés en se chevauchant à la façon d'écailles en direction du larmier de faîtage, dont la longueur est supérieure à la plus grande longueur de recouvrement d'une plaque de couverture de toit (11, 13) et dont la largeur est supérieure à la largeur de recouvrement du système des plaques de couverture de toit (11, 12, 13),
**caractérisé en ce que**
il est prévu sur l'extrémité côté faîtage des éléments supports (36, 38, 88, 90) un appui (94, 96)
lequel supporte, dans le cas de deux éléments porteurs (36, 38, 88, 90) disposés dans la même ligne de plus grande pente, l'élément support (90) proche du faîtage de façon coulissante en longueur sur l'élément support (88) voisin dans le sens du larmier à une hauteur située au-dessus de la surface du module (28) photovoltaïque reposant sur cet élément,
**en ce que** la largeur d'un module photovoltaïque (24, 26, 28, 30) est égale à un multiple entier de la largeur de recouvrement du système des plaques de couverture de toit (11, 12, 13),
**en ce que**, dans la direction du larmier de faîtage, la longueur de la surface présentant des cellules photovoltaïques à l'intérieur d'un module photovoltaïque (24, 26, 28, 30) est plus courte que la longueur de recouvrement la plus courte d'une plaque de couverture de toit (11, 13) voisine, de sorte qu'un module (24, 26, 28, 30) photovoltaïque présente côté faîtage une partie de bordure exempte de cellules photovoltaïques et
**en ce qu'**il est prévu sur un élément support (62) et au-dessous du module (24) photovoltaïque un élément de recouvrement inférieur (32, 34, 54), qui présente une gouttière (58) pouvant être positionnée au-dessous du bord longitudinal d'un module photovoltaïque (24).

2. Système photovoltaïque selon la revendication 1,
**caractérisé en ce que**,
par rapport au plan de la sous-construction du toit, la hauteur du côté supérieur d'un élément support (36, 38) est au moins égale à la hauteur de la feuillure d'eau (82) d'une plaque de couverture de toit (12) voisine latéralement, de sorte que le bord d'un module (26) photovoltaïque, à poser sur le côté feuillure d'eau d'une plaque voisine de couverture de toit (12) peut être posé en recouvrant la feuillure d'eau (82) et le bord d'un module (24) photovoltaïque à poser sur le côté feuillure de recouvrement d'une plaque voisine de couverture de toit (13) peut être posé de façon contiguë à la feuillure de recouvrement (52).

3. Système photovoltaïque selon la revendication 1 ou 2,
**caractérisé en ce que**,
l'appui (94, 96) est disposé sur le côté supérieur d'un élément support (88).

4. Système photovoltaïque selon la revendication 3,
**caractérisé en ce que**,
un élément support (90) présente sur son extrémité côté larmier un logement (92) entourant le bord d'un module (30) photovoltaïque et **en ce que** la largeur intérieure entre le bord du logement (92) et l'appui (94) disposé sur l'élément support est au moins égale à la longueur d'un module (30).

5. Système photovoltaïque selon la revendication 3 ou 4,
**caractérisé en ce que**,
l'appui (94) d'un élément support (88) est conçu comme un élément de couplage du type garrot, qui s'engage dans une fente longitudinale sur le côté inférieur de l'élément support (90) reposant dessus, afin d'empêcher un décollement de l'élément support (90) reposant dessus.

6. Système photovoltaïque selon l'une quelconque des revendications 1 à 5,
**caractérisé en ce que**,
les modules photovoltaïques (24, 26, 28, 30) sont réalisés sans cadre.

7. Système photovoltaïque selon l'une quelconque des revendications 1 à 6,
**caractérisé en ce que**,
des éléments de recouvrement inférieur (32, 34) s'étendent sur l'ensemble de la largeur d'un module photovoltaïque et présentent un bord côté larmier, conçu de façon étanche et protégé contre la neige et la pluie, qui peut être disposé dans la zone de chevauchement de deux modules (28, 26 ou 30, 28) photovoltaïques.

8. Système photovoltaïque selon la revendication 7,
**caractérisé en ce que**,
l'élément de recouvrement inférieur (32, 34) présente des ouvertures d'aération sur son bord côté larmier.
